Europäisches Patentamt

(19) European Patent Office

Office européen des brevets

(11) Numéro de publication: **0 069 635**

**A1**

(12) # DEMANDE DE BREVET EUROPEEN

(21) Numéro de dépôt: **82401164.7**

(22) Date de dépôt: **24.06.82**

(51) Int. Cl.³: **F 21 V 7/22**
**C 23 C 13/02, C 23 C 15/00**

(30) Priorité: **26.06.81 FR 8112658**

(43) Date de publication de la demande:
**12.01.83 Bulletin 83/2**

(84) Etats contractants désignés:
**FR IT**

(71) Demandeur: **EQUIPEMENTS AUTOMOBILES MARCHAL**
**26, rue Guynemer**
**F-92132 Issy-les-Moulineaux(FR)**

(72) Inventeur: **Bodin, Claude**
**La Meneudière Chemin des Bussières**
**Tours-en-Sologne 41250 Bracieux(FR)**

(72) Inventeur: **Gouin, Alain**
**La Cave**
**F-41330 La Chapelle Vendomoise(FR)**

(74) Mandataire: **Peuscet, Jacques**
**3, Square de Maubeuge**
**F-75009 Paris(FR)**

(54) **Procédé de fabrication d'une surface métallique réfléchissante, réflecteur obtenu par ledit procédé et son utilisation pour un projecteur d'éclairage.**

(57) Procédé de fabrication d'une surface métallique réfléchissante, notamment pour l'obtention de réflecteurs de projecteur d'éclairage de véhicules automobiles. Dans ce procédé, on projette une couche de résine sur la surface métallique brute; sur ladite couche de résine durcie, on projette une couche contenant un métal pris dans le groupe formé par le nickel, les alliages nickel-chrome, les alliages des composés métalliques susmentionnés avec l'aluminium, et le silicium; puis, si la couche précitée contient moins de $n$ % en poids d'aluminium, on projette sur elle un fin revêtement contenant un métal pris dans le groupe formé par l'aluminium et ses alliages à plus de $n$ % en poids, $n$ étant un nombre au plus égal à 100, dont la valeur correspond à l'état de brillance minimum tolérable pour la surface métallique réfléchissante à obtenir. L'invention a également pour objet les réflecteurs obtenus par ce procédé ainsi que l'utilisation de ces réflecteurs pour des projecteurs d'éclairage.

1

PROCEDE DE FABRICATION D'UNE SURFACE METALLIQUE REFLECHIS-
SANTE, REFLECTEUR OBTENU PAR LEDIT PROCEDE ET SON UTILI-
SATION POUR UN PROJECTEUR D'ECLAIRAGE.

La présente invention a trait à un procédé de fabrication d'une surface métallique réfléchissante, notamment utilisable pour constituer un réflecteur destiné en particulier à un projecteur de véhicule automobile.

On sait que, pour certaines pièces métalliques à usage industriel, on cherche à obtenir des surfaces présentant un pouvoir réfléchissant très élevé ; c'est notamment le cas de pièces servant à réfléchir des ondes lumineuses ou calorifiques, par exemple des réflecteurs destinés à des projecteurs de véhicules automobiles. Pour ce faire, on dépose, par métallisation sous vide, un revêtement d'aluminium sur la surface de la pièce préalablement traitée. Dans un procédé classique, on fait subir à la surface métallique, que l'on veut aluminer, un polissage, puis on applique sur la surface polie, en plusieurs couches, une épaisseur suffisante de vernis en vue d'obtenir un état de surface satisfaisant. Cette technique présente principalement l'inconvénient d'être délicate, longue et onéreuse. On a donc déjà proposé, dans le brevet français 2 304 690, un perfectionnement de cet état de la technique dans lequel on applique, en premier lieu, sur la surface métallique non polie une couche de résine en poudre ; dans lequel on réalise, en deuxième lieu, la fusion et le durcissement de la couche de résine sur son support ; et dans lequel on procède, en troisième lieu, au dépôt d'un revêtement d'aluminium brillant sur la surface ainsi prétraitée. Si la résine est suffisamment polymérisée sur son support avant le dépôt d'aluminium, cette technique donne satisfaction pour des surfaces qui ne subissent pas un échauffement ultérieur relativement important ; mais si le réchauffement ultérieur est important, soit au cours de la mise en fonction de la pièce, soit au cours d'une opération ultérieure de fini-

2

tion, dans ce cas on a constaté que la couche d'aluminium brillant avait tendance à se ternir.

Pour le cas de la fabrication des réflecteurs de projecteurs automobiles, il est clair que le réflecteur subit toujours une augmentation de température importante en cours de fonctionnement, au voisinage de la lampe d'éclairage. Il était donc nécessaire, pour le cas des réflecteurs de véhicules automobiles, de remédier à ce risque de détérioration des qualités optiques de la surface réfléchissante. Dans le brevet français 2 304 690 susmentionné, on a déjà décrit la mise en place, sur la couche de résine, d'une couche de vernis phénolique ou hydrosoluble compatible avec ladite couche de résine ; cette couche de vernis améliore l'accrochage du revêtement d'aluminium sur la résine et on a constaté que sa présence faisait disparaître tout risque de voir la surface réfléchissant se ternir lors d'une élévation ultérieure de la température. On pense, sans que cette explication puisse être aucunement limitative, que le ternissement est dû à la différence des coefficients de dilatation existant entre la résine et la couche d'aluminium brillant, et que l'interposition du vernis évite les inconvénients pouvant provenir d'un dépassement de la limite élastique de l'aluminium en raison de la forte dilatation de la résine qui constitue son support.

L'utilisation d'un tel vernis entre la couche de résine et l'aluminium brillant donne, donc, parfaitement satisfaction pour la fabrication des réflecteurs de projecteurs de véhicules automobiles, mais elle présente plusieurs inconvénients : en premier lieu, le vernis utilisé est un produit relativement onéreux, en deuxième lieu, la mise en place du vernis constitue une étape supplémentaire dans la fabrication des projecteurs et augmente, donc, le temps et le coût de fabrication ; en troisième lieu, le vernis nécessite une énergie de séchage. On constate donc que, si la mise en place d'un vernis donne satisfaction sur le plan pratique, elle comporte des inconvénients sur le plan financier.

3

La présente invention a pour but de proposer un perfectionnement à ce type de fabrication de surfaces métalliques réfléchissantes. Selon ce perfectionnement, on supprime la mise en place d'un vernis entre la couche de résine et la pellicule métallique brillante du réflecteur mais, néanmoins, on évite tout risque de ternissement lors d'une élévation de température ultérieure de la pièce après fabrication. Une telle pièce peut, donc, être utilisée sans difficulté pour constituer un réflecteur de projecteur d'éclairage.

Selon l'invention, on a constaté que si l'on dépose, directement sur la couche de résine une couche comportant, sous forme combinée ou non avec un autre élément tel que l'oxygène, du silicium, du nickel ou un alliage nickel-chrome, il ne se produit plus aucun risque de ternissement de la surface réfléchissante déposée sur la couche de résine. Si la couche portée directement par la couche de résine comporte, en plus du nickel ou d'un alliage nickel-chrome, un pourcentage d'aluminium suffisamment élevé, elle a des caractéristiques réfléchissantes suffisantes pour pouvoir constituer à elle seule la pellicule métallique réfléchissante que l'on désire. Par contre, si la couche mise en place directement sur la couche de résine ne comporte que peu ou pas d'aluminium, il convient de mettre en place, sur cette couche métallique, un revêtement métallique contenant un fort pourcentage d'aluminium, ce revêtement métallique pouvant être de l'aluminium pur ou un alliage d'aluminium. En d'autres termes, selon l'invention, ou bien on met en place sur la couche de résine une couche unique comportant un fort pourcentage d'aluminium et un faible pourcentage de nickel ou d'alliage nickel-chrome, ou bien on met en place une couche à faible pourcentage d'aluminium (ou sans aluminium) constituée de silicium, de nickel ou d'un alliage nickel-chrome, puis une couche à fort pourcentage d'aluminium (ou constituée par de l'aluminium pur). Dans les deux cas, ce procédé est beaucoup plus

4

avantageux que celui qui consistait à mettre en place avant la couche réfléchissante une couche intermédiaire de vernis. En effet, dans la première hypothèse ci-dessus évoquée, on ne met en place qu'une couche unique sur la couche de résine ; dans la deuxième hypothèse ci-dessus évoquée, on met en place une couche métallique puis on la recouvre par un revêtement métallique, mais la couche et le revêtement peuvent être réalisés dans le même appareil de transfert sous vide, ce qui, en fait, supprime complètement un temps de fabrication et les coûts correspondants.

Le transfert sous vide visant à réaliser la mise en place de la couche susmentionnée et, éventuellement, du revêtement qui la surmonte, peut être une métallisation sous vide de type classique : elle se réalise alors dans une enceinte sous pression réduite en disposant les pièces à métalliser à l'intérieur de l'enceinte en vis-à-vis d'une charge métallique que l'on porte à haute température par effet Joule ; en raison de l'énergie thermique apportée, la charge se volatilise et les particules vont se condenser sur les pièces à métalliser. Les températures, auxquelles il faut porter les charges utilisées dans le procédé selon l'invention, dépendent essentiellement de la nature du constituant de la charge ; à titre indicatif, on peut indiquer une température d'environ 1800-1900°C, lorsque la charge est constituée d'aluminium, une température d'environ 1900-2000°C, lorsque la charge est constituée de silicium et une température d'environ 1100°C lorsque la charge est constituée de monoxyde de silicium. On peut aussi utiliser pour mettre en place la couche susmentionnée et, éventuellement, le revêtement, qui la surmonte, une pulvérisation cathodique. Dans ce cas, le transfert s'effectue, de façon connue, dans une enceinte sous pression réduite où les pièces à métalliser constituent des anodes et où le matériau à transférer constitue une cathode, un champ électrique intense étant établi entre anodes et cathode.

5

Le champ ionise le gaz résiduel de l'enceinte et les ions positifs viennent bombarder la cathode ; il en résulte un dépôt sur les anodes du matériau cathodique.

La mise en place de la couche de résine sur le substrat métallique est réalisée comme indiqué dans le brevet français 2 304 690 ; on peut, notamment, effectuer un pistoletage électrostatique d'une poudre de résine ; la résine peut être une résine polyuréthane, polyester, acrylique ou époxyde. L'épaisseur de la couche de résine est, généralement, comprise entre 30 et 80 microns.

La présente invention a, donc, pour objet un nouveau procédé de fabrication d'une surface métallique réfléchissante, dans lequel on applique sur la surface métallique brute une couche de résine en poudre, on fond et on durcit "in-situ" ladite couche et on y transfère une pellicule métallique brillante, caractérisé par le fait que l'on transfère, directement sur la couche de résine, une fine couche contenant un élément métallique pris dans le groupe formé par le nickel, les alliages nickel-chrome, les alliages des composés métalliques précédents avec l'aluminium, et le silicium ; puis, uniquement si la couche précitée contient moins de n % d'aluminium, on transfère sur cette couche un fin revêtement métallique brillant d'un métal pris dans le groupe formé par l'aluminium et ses alliages à plus de n % en poids d'aluminium, n étant un nombre au plus égal à 100, dont la valeur correspond à l'état de brillance minimum tolérable pour la surface métallique réfléchissante à obtenir.

Dans un mode préféré de mise en oeuvre, on réalise les transferts de couche et, éventuellement, de revêtement par métallisation sous vide, c'est-à-dire par dépôt sous pression réduite, par volatilisation et condensation, à partir d'au moins une charge du matériau à transférer.

Dans une première variante, on réalise un transfert à partir d'une charge contenant, sous une forme

6

combinée ou non avec un autre élément tel que l'oxygène, du nickel, un alliage nickel-chrome, un alliage des composés métalliques précédemment cités avec l'aluminium (à une teneur inférieure à n % en poids d'aluminium, n ayant la signification précédemment définie), ou du silicium, ce transfert étant suivi d'un autre transfert réalisé à partir d'une charge constituée d'aluminium pur ou d'un alliage à plus de n % en poids d'aluminium ; on peut, avantageusement, prévoir que le premier transfert soit réalisé à partir d'une charge de silicium alors que le deuxième est réalisé à partir d'une charge d'aluminium.

Dans une autre variante de mise en oeuvre du procédé selon l'invention, on réalise, par métallisation sous vide de la couche de résine, un transfert à partir d'une charge unique comprenant, sous une forme combinée ou non avec un autre élément tel que l'oxygène, de l'aluminium et au moins un composé métallique pris dans le groupe formé par le nickel et les alliages nickel-chrome, la charge unique contenant au moins n % en poids d'aluminium ; selon une première possibilité, la charge est constituée d'un alliage des composés métalliques présents ; selon une autre possibilité, la charge est constituée d'un ensemble de plusieurs charges de natures différentes.

Selon une technique déjà connue, on peut recouvrir la pellicule métallique brillante, qui surmonte la couche de résine, par une projection protectrice de silicium, le silicium venant, cette fois, en surface au-dessus de la couche réfléchissante proprement-dite. Dans cette hypothèse, la projection de silicium s'effectue, avantageusement, dans le même appareil de métallisation sous vide que les projections précédentes et, par conséquent, le prix de revient n'est pas sensiblement augmenté. Cependant, la présence d'une telle couche de silicium en surface n'est réellement nécessaire que lorsque la pellicule brillante n'est aucunement protégée de l'extérieur, notamment lorsqu'il s'agit de réflecteurs insérés dans des projecteurs ventilés. Au contraire, cette projection superficielle de silicium est absolument inutile, si le réflecteur est destiné à être utilisé dans un projecteur, dont le bloc optique est étanche, comme c'est le cas lorsque l'on colle la glace de projecteur directement sur la bordure frontale du réflecteur.

La présente invention a, également pour objet, le produit industriel nouveau que constitue un réflecteur obtenu par le procédé ci-dessus défini, ce réflecteur comportant, sur une embase métallique de forme sensiblement parabolique concave, une couche de résine portant une pellicule métallique brillante, caractérisé par le fait que la résine porte directement une couche contenant au moins un métal, sous une forme combinée ou non avec un autre élément tel que l'oxygène, pris dans le groupe formé par le nickel, les alliages nickel-chrome, les alliages des composés métalliques précédents avec l'aluminium, et le silicium, ladite couche, si elle contient moins de n % en poids d'aluminium, étant recouverte d'un revêtement contenant un métal pris dans le groupe formé par l'aluminium et ses alliages à plus de n % en poids, l'épaisseur totale de la pellicule portée par la résine étant comprise entre 0,05 et 0,1 micron, n ayant la signification précédemment indiquée.

Dans une première variante préférée de réalisation, la résine porte une couche contenant moins de n % d'aluminium et le revêtement est constitué d'aluminium ; la résine peut porter, notamment, une couche de silicium ; le revêtement peut être constitué d'un alliage d'aluminium et d'au moins un métal pris dans le groupe formé par le silicium, le nickel et les alliages nickel-chrome, l'aluminium étant présent à au moins n % en poids ; le revêtement peut, par exemple, être constitué d'un alliage d'aluminium et de silicium contenant de 88 à 99 % en poids d'aluminium.

Dans le cas où il est nécessaire de protéger en surface le réflecteur, la pellicule brillante constituée par la couche portée par la résine et, éventuelle-

8

ment, le revêtement qui la surmonte, est recouverte, de façon connue, par une fine projection de silicium.

La présente invention a, enfin, pour objet, l'utilisation d'un réflecteur tel que ci-dessus défini comme élément d'un projecteur d'éclairage. Dans cette utilisation, on constate que l'augmentation de température au voisinage de la lampe d'éclairage du projecteur n'entraîne aucun ternissement de la surface réfléchissante malgré l'absence de vernis entre la couche de résine et la pellicule métallique brillante qu'elle supporte.

Pour mieux faire comprendre l'objet de l'invention, on va en décrire maintenant, à titre d'exemple purement illustratif et non limitatif, un mode de mise en oeuvre.

La pièce métallique traitée est destinée à constituer un réflecteur de projecteur pour véhicule automobile. Ce réflecteur est réalisé à partir d'une tôle brute non traitée ayant, sensiblement, 0,7 mm d'épaisseur et comportant des aspérités de surface que l'on peut évaluer comme étant de l'ordre de 2 microns. On réalise d'abord un pré-traitement de dégraissage par une lessive alcaline ou par un solvant, comme le trichloréthylène. L'opération de dégraissage est suivie d'une application au pistolet électrostatique d'une poudre de polyuréthane. Le poudrage est suivi d'une cuisson de la couche de polyuréthane effectuée à une température de 220°C pendant 12 mn ; on refroidit à la température ambiante pendant 20 mn ; la couche de polyuréthane obtenue a une épaisseur d'environ 40 à 70 microns.

On met en place la pièce ainsi préparée dans une enceinte de métallisation sous vide comportant d'une part, une nacelle contenant du silicium et d'autre part, un filament spirale en tungstène portant une charge d'aluminium pur (99,99%). On applique à la nacelle une différence de potentiel suffisante pour porter le silicium à environ 2000°C par effet Joule, on obtient de la sorte une couche de bioxyde de silicium sur la couche de résine et

9

on applique ensuite une différence de potentiel au filament de tungstène chargé d'aluminium pour obtenir une couche d'aluminium brillant sur la couche de bioxyde de silicium, les deux couches ayant une épaisseur de 0,05 micron environ.

On constate que l'on obtient ainsi un réflecteur de projecteur ayant de bonnes caractéristiques optiques avec une aussi bonne tenue à la corrosion que dans la technique actuelle. Les caractéristiques optiques sont maintenues lorsque l'on met en place dans le bloc optique constitué par l'ensemble (réflecteur-glace de projecteur) une lampe d'éclairage de 60 watts et que l'on alimente ladite lampe. On constate donc que l'absence d'une couche de vernis intermédiaire entre la résine et la pellicule métallique brillante n'entraîne plus aucun ternissement de la surface réfléchissante grâce à la composition particulière adoptée selon l'invention.

Il est bien entendu que le mode de réalisation ci-dessus décrit n'est aucunement limitatif et pourra donner lieu à toutes modifications désirables, sans sortir pour cela du cadre de l'invention.

10

REVENDICATIONS

1 - Procédé de fabrication d'une surface métallique réfléchissante, dans lequel on applique sur la surface métallique brute une couche de résine en poudre, on fond et on durcit "in-situ" ladite couche et on y transfère une pellicule métallique brillante, caractérisé par le fait que l'on réalise, directement sur la couche de résine, un premier transfert d'une fine couche contenant un élément métallique pris dans le groupe formé par le nickel, les alliages nickel-chrome, les alliages des composés métalliques précédents avec l'aluminium, et le silicium ; puis, uniquement si la couche précitée contient moins de n % d'aluminium, on réalise sur cette couche un second transfert d'un fin revêtement métallique brillant d'un métal pris dans le groupe formé par l'aluminium et ses alliages à plus de n % en poids d'aluminium, n étant un nombre au plus égal à 100, dont la valeur correspond à l'état de brillance minimum tolérable pour la surface métallique réfléchissante à obtenir.

2 - Procédé selon la revendication 1, caractérisé par le fait que l'on réalise chaque transfert de couche et, éventuellement, de revêtement par métallisation sous vide ou par pulvérisation cathodique à partir d'au moins une charge du matériau à transférer.

3 - Procédé selon la revendication 2, caractérisé par le fait que l'on réalise, par métallisation sous vide de la couche de résine, un premier transfert à partir d'une charge contenant, sous une forme combinée ou non avec un autre élément tel que l'oxygène, du nickel, un alliage nickel-chrome, un alliage des composés métalliques précédemment cités avec l'aluminium à une teneur inférieure à n % en poids d'aluminium, ou du silicium, ce transfert étant suivi d'un second transfert réalisé à partir d'une charge constituée d'aluminium pur ou d'un alliage à plus de n % en poids d'aluminium, n ayant la signification définie à la revendication 1.

4 - Procédé selon la revendication 3, caractérisé par le fait que l'on réalise le premier transfert à partir d'une charge de silicium et le deuxième transfert à partir d'une charge d'aluminium.

5 - Procédé selon la revendication 2, caractérisé par le fait que l'on réalise un transfert à partir d'une charge unique comprenant, sous une forme combinée ou non avec un autre élément tel que l'oxygène, l'aluminium et au moins un composé métallique pris dans le groupe formé par le nickel et les alliages nickel-chrome, la charge unique contenant au moins n % en poids d'aluminium, n ayant la signification définie à la revendication 1.

6 - Procédé selon la revendication 5, caractérisé par le fait que la charge est constituée d'un alliage des composés métalliques présents.

7 - Procédé selon la revendication 5, caractérisé par le fait que la charge est constituée d'un ensemble de plusieurs charges partielles de natures différentes.

8 - Procédé selon l'une des revendications 1 à 7, caractérisé par le fait que l'on recouvre la pellicule métallique brillante, qui surmonte la couche de résine, par une projection protectrice de silicium.

9 - Réflecteur obtenu par le procédé selon l'une des revendications 1 à 8, comportant sur une embase métallique de forme sensiblement parabolique concave, une couche de résine portant une pellicule métallique brillante, caractérisé par le fait que la résine porte directement une couche contenant au moins un métal, sous une forme combinée ou non avec un autre élément tel que l'oxygène, pris dans le groupe formé par le nickel, les alliages nickel-chrome, les alliages des composés métalliques précédents avec l'aluminium, et le silicium, ladite couche, si elle contient moins de n % en poids d'aluminium, étant recouverte d'un revêtement contenant un métal pris dans le groupe formé par l'aluminium et ses alliages à plus de n % en poids, l'épaisseur totale de la pellicule portée par la résine étant comprise

12

entre 0,05 et 0,1 micron, n ayant la signification définie à la revendication 1.

10 - Réflecteur selon la revendication 9, caractérisé par le fait que la résine porte une couche de silicium.

11 - Réflecteur selon l'une des revendications 9 ou 10, caractérisé par le fait que la résine porte une couche contenant moins de n % en poids d'aluminium, n ayant la signification définie à la revendication 1, et que le revêtement, qui surmonte ladite couche, est constitué d'aluminium.

12 - Réflecteur selon l'une des revendications 9 ou 10, caractérisé par le fait que la résine porte une couche contenant moins de n % d'aluminium, n ayant la signification définie à la revendication 1, et que le revêtement, qui surmonte ladite couche, est constitué d'un alliage d'aluminium et d'au moins un métal pris dans le groupe formé par le silicium, le nickel et les alliages nickel-chrome.

13 - Réflecteur selon la revendication 12, caractérisé par le fait que le revêtement, qui surmonte la couche métallique portée par la résine, est constitué d'un alliage aluminium-silicium contenant de 88 à 99% en poids d'aluminium.

14 - Réflecteur selon l'une des revendications 10 à 13, caractérisé par le fait que la pellicule brillante portée par la résine est recouverte par une fine projection de silicium.

15 - Utilisation d'un réflecteur selon l'une des revendications 10 à 14 comme élément d'un projecteur d'éclairage.

**Office européen des brevets**

# RAPPORT DE RECHERCHE EUROPEENNE

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. ³) |
|---|---|---|---|
| X | DE-A-2 417 558 (DEUTSCHE GOLD- UND SILBER SCHEIDEANSTALT)  * en entier * | 1,2,5, 6,8,10 ,12,16 | F 21 V 7/22  C 23 C 13/02  C 23 C 15/00 |
| A | FR-A-1 324 047 (N.V. PHILIPS)  * page 2, colonne 1, lignes 1-25 * | 12 | |

DOMAINES TECHNIQUES RECHERCHES (Int. Cl. ³)

F 21 V
C 23 C

Le présent rapport de recherche a été établi pour toutes les revendications

| Lieu de la recherche | Date d'achèvement de la recherche | Examinateur |
|---|---|---|
| LA HAYE | 20-09-1982 | FOUCRAY R.B.F. |